# EUROPEAN PATENT APPLICATION

(11) **EP 3 798 688 A1**
(43) Date of publication of application: **31.03.2021**
(21) Application number: 19199225.4
(22) Date of filing: 24.09.2019
(51) Int. Cl.: G02B 3/00, H01L 31/0475, H01L 31/054, H02S 20/30

(54) **OPTOMECHANICAL SYSTEM FOR CONVERTING LIGHT ENERGY OF HIGHLY-DIRECTIONAL INCIDENT LIGHT OR FOR TRANSMITTING HIGHLY-DIRECTIONAL INCIDENT LIGHT AS WELL AS FOR TRANSMITTING DIFFUSE INCIDENT LIGHT AND CORRESPONDING METHOD FOR CONVERTING AND TRANSMITTING LIGHT ENERGY**

(71) Applicant: Insolight SA, 1007 Lausanne (CH)
(72) Inventor: GERLICH, Florian, 1007 Lausanne (CH); COULOT, Laurent, 1003 Lausanne (CH); ACKERMANN, Mathieu, 1006 Lausanne (CH); BORY, Noé, 1003 Lausanne (CH); NARDIN, Gaël, 1027 Lonay (CH); SCHUPPISSER, David, 1007 Lausanne (CH)
(74) Representative: BOVARD AG

(57) **Abstract**

The present invention relates to an optomechanical system (100) for converting or transmitting a highly-directional component (81) of incident light (80) and for transmitting a diffuse component (82) of incident light (80), comprising
▪ an optical arrangement (40) comprising a first optical layer (41), wherein the first optical layer (41) comprises a plurality of primary optical elements (47);
▪ a light energy conversion layer (50) at least partially transparent to light and comprising a plurality of distant light energy conversion elements (51) capable of converting light energy in an output energy;
▪ a shifting mechanism (60) for moving the optical arrangement (40) relative to the light energy conversion layer (50) or vice versa; and
▪ a frame element (10) to which either the optical arrangement (40) or the light energy conversion layer (50) is attached,

wherein the shifting mechanism (60) is arranged to displace the optical arrangement (40) or the light energy conversion layer (50) translationally relative to the frame element (10), through one or more translation element (65),
wherein the primary optical elements (47) of the first optical layer (41) and the shifting mechanism (60) are designed such that the highly-directional component (81) of incident light (80) is directable onto the light energy conversion elements (51) of the light energy conversion layer (50) and such that the diffuse component (82) of incident light (80) is transmittable through the regions of the light energy conversion layer (50) not covered by the light energy conversion elements (51), and
wherein the total output power of the light energy conversion elements (51) and/or the amount of light transmitted through the optomechanical system (100) is adjustable.

Furthermore, the present invention also relates to a corresponding method for converting light energy with the aforementioned optomechanical system.

## Description

### Technical field of the invention

The present invention relates to the technical field of optical systems, more specifically to the technical field of optomechanical systems. In particular, the present invention relates to an optomechanical system for converting light energy in another type of energy and the corresponding method. More precisely, the present invention relates to an optomechanical system, which allows for high efficiency conversion of light energy of highly-directional incident light or transmission of the highly-directional incident light and for transmission of diffuse light. Such optomechanical systems can in particular be used in an advantageous way in the construction of solar panels for the fields of agricultural and building integrated photovoltaics. The present invention relates, furthermore, to the use of an inventive optomechanical system in the field of agriculture and as a window, skylight and façade component.

### Background of the invention

More and more, photovoltaic plants and agriculture are competing for land usage. Due to their relatively low energy conversion yield, both processes require very large open spaces with similar features such as decent amount of solar irradiance, relatively flat ground with minimal shading or obstacles, reasonable proximity with urban areas to alternatively produce electricity or grow food. Therefore, there is a strong incentive for an invention allowing both usages to share the same land.

Installing conventional silicon photovoltaics (PV) modules above crops or greenhouses is one solution. Conventional PV modules are very cheap and can be produced in mass. They are, however, completely opaque and therefore shade the plants placed below them if they are not sufficiently spaced apart. Spacing them apart, on the other hand, is not very effective, as it results in a decrease of the electricity production without completely removing shadows, which due to the sun movement are moving throughout the course of the day and depriving plants from sunlight. In this manner, the land might be shared but the overall utilization of sunlight per unit area is not significantly increased.

Concentrated photovoltaics (CPV) is another solution with several key advantages over conventional silicon PV. First, CPV modules can reach efficiencies well over 30%, whereas high-end silicon PV barely exceeds 20%. Higher efficiency means a higher power density, i.e. power per unit area, and therefore a much better usage of the available sunlight. Second, the use of concentrating optics in CPV reduces by several hundred times the amount of photovoltaic material, i.e. solar cell area, required. For instance, a CPV module with a concentration factor of 500X requires only 0.2% of its backplane to be covered with solar cells. If these PV cells are mounted and interconnected on a transparent substrate, the resulting CPV module can be semi-transparent or translucent. Third, due to fundamental physical limitations, high concentration optics can efficiently focus only collimated sunlight. Therefore, sunlight scattered by the sky, diffused by the clouds or reflected by the environment can be transmitted through the CPV module to the ground with almost no shadowing. Finally, since the CPV modules require a tracking system to keep the solar cells in focus of the optics when the sun is moving, they can actively adjust the amount of direct sunlight converted to electricity by the cells, and the amount of sunlight which gets through unimpeded.

However, classical CPV trackers have an important drawback. They are very heavy and complex structures, which require a large volume of free space to rotate around two axes, in order to follow the course of the sun in the sky. If they are mounted on the ground, they are likely to impede the movements of agricultural machines. Due to their size and weight, they are not compatible with rooftop installations and especially too heavy for greenhouse structures.

Building Integrated Photovoltaics (BIPV) is another field of application with similar technical requirements. In most densely-packed urban centers, PV installations are limited to rooftops due to the very high cost of land and lack of clear ground area. However, the total area available on rooftops is not sufficient to power buildings with more than a couple of floors, especially with the limited efficiency of conventional silicon-based PV modules. In medium-size apartment buildings or high-rise towers, rooftops can only supply a fraction of the required power due to the unfavorable aspect ratio of such constructions. Several solutions have been therefore developed to try to take advantage of other surfaces such as façades, windows or skylights.

Conventional silicon PV modules or cells can be mounted on façades, but their inherent opacity limits their use on buildings covered mostly with windows. Furthermore, as stated above conversion efficiency of conventional PV cells is typically limited to less than 20%.

Another known solution is to integrate silicon cells directly inside double-glazed or triple-glazed windows. However, these silicon cells have to be spaced-apart to let the required light in, which produces unaesthetic alternance of shadow and light inside the building, and again reduces the generated power per unit area.

Yet another known solution for windows or skylights is to integrate transparent or translucent organic materials or chemical compounds capable of generating electricity. This solution has the main and important drawback of a very limited efficiency of typically well below 10%.

For all the above reasons, there is a need for an optomechanical system, which allows for high efficiency conversion of light energy of highly-directional incident light while allowing transmission of diffuse light. The optomechanical system comprises a shifting mechanism that moves only within a limited volume, in order to track the apparent movements of the sun while still ensuring compatibility with fixed-tilt installations such as rooftops.

### Summary of the invention

Thus, the object of the present invention is to propose a new optomechanical system, corresponding method and uses for converting and transmitting light energy, in which the above-described drawbacks of the known systems and methods are completely overcome or at least greatly diminished.

An object of the present invention is in particular to propose an optomechanical system and a corresponding method for converting light energy, thanks to which it is possible to convert or to transmit the light energy of the highly-directional component of incident light, as for instance the light coming directly from the sun, while transmitting the diffuse component of the incident light through the optomechanical system.

According to the present invention, these objects are achieved in particular through the elements of the four independent claims. Further advantageous embodiments arise from the dependent claims and the description. Features disclosed herein in different embodiments can also be combined easily by a person who is skilled in the art.

In particular, in a first aspect, the objects of the present invention are achieved by an optomechanical system for converting or transmitting a highly-directional component of incident light and for transmitting a diffuse component of incident light, comprising
▪ an optical arrangement comprising a first optical layer, wherein the first optical layer comprises a plurality of primary optical elements;
▪ a light energy conversion layer at least partially transparent to light and comprising a plurality of distant light energy conversion elements capable of converting light energy in an output energy;
▪ a shifting mechanism for moving the optical arrangement relative to the light energy conversion layer or vice versa; and
▪ a frame element to which either the optical arrangement or the light energy conversion layer is attached,
wherein the shifting mechanism is arranged to displace the optical arrangement or the light energy conversion layer translationally relative to the frame element, through one or more translation elements,
wherein the primary optical elements of the first optical layer and the shifting mechanism are designed such that the highly-directional component of incident light is directable onto the light energy conversion elements of the light energy conversion layer and such that the diffuse component of incident light is transmittable through the regions of the light energy conversion layer not covered by the light energy conversion elements, and
wherein the total output power of the light energy conversion elements and/or the amount of light transmitted through the optomechanical system is adjustable.

Thanks to the present invention, it is possible to efficiently convert light energy of the highly-directional component of the incident light while transmitting trough the optomechanical system the diffuse component of the incident light. The converted light is then used for the production of energy by the optomechanical system while the transmitted diffuse light is available for instance for illuminating plants placed below the system and therefore to enable their growth or for providing light in a building when the optomechanical system is used as a window, skylight or façade component.

The shifting mechanism of the optomechanical system can be used to move either the optical arrangement or the light energy conversion layer in order to modulate and control the amount of light energy converted by the light energy conversion elements and the amount of light transmitted through the system. In particular, with the shifting mechanism, it is possible to compensate for the movement of the sun relative to the optomechanical system during the day and to place the light energy conversion elements always at the most favourable position relative to the primary optical elements of the optical arrangement to maximize the production of energy without the need to use an external tracker as in the CPV modules known from the prior art.

Nevertheless, it is important to understand that the shifting mechanism can be also used to maximize the amount of transmitted light through the optomechanical system and therefore to maximize the amount of light arriving for instance at plants paced below the system in order to favour their growth. In particular, the shifting mechanism can be used to intentionally misalign the primary optical elements of the optical arrangement relative to the light energy conversion elements, in order to transmit the highly-directional component of the incident light to the plants. This is advantageous when the plants require more irradiance than what diffuse sunlight alone can provide over one day. For instance, the optomechanical system can provide a programmable shifting mechanism configured to automatically misalign the primary optical elements relative to the light energy conversion elements in the early mornings or late afternoons, when the sun is low and the efficiency of light energy conversion would anyway be minor. More generally, the optomechanical system can provide a programmable shifting mechanism configured to misalign the primary optical elements relative to the light energy conversion elements at any time during the day, e.g. based on manual inputs or the feedback of one or more sensors measuring the amount of energy received by the plants and/or the amount of power produced by the light energy conversion elements. While the light energy conversion elements can be PV cells, they could also be of other types of modules for light energy conversion as for instance thermal modules for the conversion of light energy in heat. The light energy conversion elements of the optomechanical system of the present invention can also be of different types, for instance a mix of PV cells and thermal cells.

In one preferred embodiment of the present invention, the shifting mechanism is arranged to displace the optical arrangement or the light energy conversion layer in such a way that the total output energy power of the light energy conversion elements can be maximized. With this, the optomechanical system is configured to maximize at all time the amount of total power produced.

In another preferred embodiment of the present invention, the shifting mechanism comprises one or more guiding elements, such as double universal joints, for instance double cardan joints, double ball joints and/or one or more flexible guiding elements, such as a spring or leaf spring, in such a way that the one or more guiding elements or flexible guiding elements are capable of limiting the degrees of freedom of the optical arrangement and/or of the light energy conversion layer. The one or more guiding elements, advantageously flexible guiding elements, capable of limiting the degrees of freedom of the one or more translation elements are arranged in such a way that the relative position of the optical arrangement and the light energy conversion layer can be accurately adjusted by the shifting mechanism, and more specifically avoiding or minimizing relative rotations. In this manner, the shifting mechanism ensures that the relative movement of the optical arrangement and the light energy conversion layer occurs only in translation, without rotation. Flexible guiding elements based on mechanical deformation are advantageous for mechanical systems requiring high reliability and long lifetime, such as the optomechanical system of the present invention, since they do not involve friction and do not suffer from wear. In addition, their rigidity in the direction perpendicular to the movement and their precision in carrying out small displacements qualify them particularly for this type of systems.

In another preferred embodiment of the present invention, the one or more guiding elements and/or the one or more flexible guiding elements are capable of suppressing any rotational movement between the optical arrangement and the light energy conversion layer. This is of particular importance since any spurious rotational movement between the optical arrangement and the light energy conversion layer results in a misalignment between the primary optical elements of the optical arrangement and the light energy conversion elements and finally in a decrease of the output power of the system.

In a further preferred embodiment of the present invention, the light energy conversion layer is directly attached to the optical arrangement by means of the guiding elements and/or the flexible guiding elements. The direct mechanical link provided by these guiding elements ensures a more accurate positioning of the optical arrangement and the light energy conversion layer relative to each other.

In another preferred embodiment of the present invention, the guiding elements and/or the flexible guiding elements are arranged to guide the movement of the optical arrangement or the light energy conversion layer on a paraboloid or on a spherical trajectory. With this, the light energy conversion elements can be positioned at the focal point of the primary optical elements independently of the angle of incidence of the highly-directional component of the incident light. Furthermore, a curved displacement trajectory can be advantageous to increase the efficiency and/or the angular acceptance of the optomechanical system.

In a further preferred embodiment, the optomechanical system comprises a gutter attached to the frame for collecting rainwater falling on the optomechanical system. By means of the gutter, it is possible to collect rain falling on the front surface of the optomechanical system and distribute collected water to the plants below. This is advantageous to avoid depriving plants below the optomechanical system of water and to avoid or reduce the need for artificial irrigation.

In yet another preferred embodiment of the present invention, the optomechanical system comprises a water distribution system for distributing the collected rainwater. This is particularly advantageous in applications in the agricultural field and allows for distribution of the collected rainwater to the plants placed below or nearby the optomechanical system.

In a further preferred embodiment of the present invention, the primary optical elements are of reflective type such as mirrors or of refractive type such as lenses including plano-convex, plano-concave, bi-convex, bi-concave, meniscus type and aspheric curvature having polynomial shape. Optical elements such as lenses with aspheric curvature, advantageously with an aspheric curvature described by a polynomial of order three or higher, and in particular aspheric curvature including one or more inflection points, allow for a higher design freedom to increase the angular acceptance and reduce optical aberrations. This allows for efficiently concentrating the highly-directional component of the incident light onto the light energy conversion elements. Thanks to the higher concentration factor, high-efficiency PV cells can be used since the area of expensive light energy conversion elements can be reduced, thus decreasing the cost. Furthermore, concentration typically increases the efficiency of the light energy conversion elements. With smaller light energy conversion elements, the surface of the light energy conversion layer able to transmit light is larger, which allows to transmit more diffuse light to the objects, for instance plants, placed below the system.

In yet another preferred embodiment of the present invention, the primary optical elements have a hexagonal or rectangular tiling contour and are arranged in an array. This permits to cover completely the surface of the optical arrangement with the primary optical elements without having any gap between these elements.

In another preferred embodiment of the present invention, the light energy conversion elements are PV cells, for instance high-efficiency PV cells. With this, the highly-directional component of the incident light can be directly converted into electricity. Thanks to the focusing power of the optical layer, the surface covered by these cells is smaller than for conventional PV modules and the surface of the light energy conversion layer that is capable of transmitting the diffuse component of the incident light is bigger. Therefore, with high-efficiency PV cells, the highly-directional component of the incident light can be more efficiently converted into electricity while simultaneously transmitting diffuse light through the optomechanical system. This is particularly advantageous when the optomechanical system is used in the agricultural field or integrated to a building.

The light energy conversion elements can be single- or multi-junction PV cells. Multi-junction PV cells are very efficient but expensive while single-junctions PV cells are less efficient but much cheaper. Furthermore, the light energy conversion elements can advantageously be triple-junction cells based on III-V semiconductors, such as GaInP/GaInAs/Ge or InGaP/GaAs/GalnAsNSb, which can reach efficiencies of more than 40% under concentration. Alternatively, the light energy conversion elements can be dual-junction cells or tandem cells, such as perovskites-silicon tandem cells, which have the potential to offer better performance-to-cost ratios. It should be noted that the junctions of the multi-junction cells can be grown by epitaxial processes or stacked mechanically. In case of single-junction cells, they can advantageously be mono-crystalline silicon cells, poly-crystalline silicon cells, or thin-film solar cells such as Copper Indium Gallium Selenide (CiGS), Cadmium Telluride (CdTe) or amorphous silicon, which are all mass-produced at very low cost. Nonetheless, they can also be made from other technologies/materials such as hetero-junction silicon cells or perovskites.

In another preferred embodiment of the present invention, secondary optical elements of refractive type and/or of reflective type are mounted directly onto the light energy conversion elements in order to further focus the highly-directional component of incident light onto the light energy conversion elements. The secondary optical elements mounted directly on the light energy conversion elements have two main advantages. First, they ensure a better collection of the highly-directional component of the incident light by the light energy conversion elements since the secondary optical elements allow for the collection of a portion of the highly-directional component of incident light that would otherwise miss these light energy conversion elements and be lost. Second, the secondary optical elements allows for increasing the alignment tolerance between the primary optical elements and the light energy conversion elements. In case several light energy conversion elements are mounted on the light energy conversion layer, the light concentrated and transmitted by each primary optical element of the optical arrangement can be slightly misaligned. The secondary optical elements minimize the losses related to this misalignment.

In yet another preferred embodiment of the present invention, the light energy conversion layer is encapsulated in an encapsulating layer, which is sandwiched between a first protective layer and a second protective layer. The encapsulating layer can for instance be made out of ethylene-vinyl acetate (EVA), or poly-ethylene-vinyl acetate (PEVA). Thanks to the presence of the encapsulating layer and of the first and second protective layer, it is possible to protect the light energy conversion elements from stress and contaminants, such as humidity or dust. The two protective layers can advantageously be made of glass for its rigidity and resistance to shocks. Alternatively, they can be made of a polymer such as PET to make a more lightweight optomechanical system.

In another preferred embodiment of the present invention, a light scattering layer is placed below the light energy conversion layer in the direction opposite to the optical arrangement. By means of the light scattering layer, it is possible to homogenize the illuminance and to hide small features from view. This permits to make the optomechanical system more aesthetic, which is particularly advantageous for BIPV applications.

In yet another preferred embodiment of the present invention, light spectrum shifting elements are integrated into the light energy conversion layer in-between the light energy conversion elements. Thanks to the shifting mechanism, the highly-directional light focused by the optical layer can be directed to these light spectrum shifting elements in order to change the spectrum of the light transmitted by the optomechanical system. This is advantageous in agricultural applications in order to transmit light with a spectrum optimized for the plants being grown below the optomechanical system (e.g. blue-shifted light below 450nm or red-shifted light above 650nm). This is also advantageous in BIPV applications to tune the color "temperature" of the light being transmitted into the building (e.g. to transmit "colder" or "warmer" light depending on the time of the day or the weather conditions).

In yet another preferred embodiment of the present invention, light emitting elements are provided on the light energy conversion layer. Thanks to this embodiment, the optomechanical system can also be used as a lighting fixture, which is advantageous in various scenarios. In case the optomechanical system is installed above agricultural land, the light emitting elements can provide light to the plants in the absence of sunlight, for instance at night or on cloudy day or provide additional light within a specific spectral band, optimized for the plants being grown. In case the optomechanical system is installed as a skylight, the light emitting elements can provide lighting inside the building when natural sunlight is not sufficient, for instance at night or on cloudy days. Alternatively, by mounting the light emitting elements on the same side of the light energy conversion layer as the light energy conversion elements, they can emit light towards the outside of the building, and be used for architectural lighting, street lighting or advertisement, for instance as billboard.

Advantageously, the light emitting elements are light emitting diodes. The light emitting elements can be mounted on the front side of the light energy conversion layer, i.e. facing the optical arrangement, and in-between the light energy conversion elements.

In a further preferred embodiment of the present invention, the light emitting elements are placed on the opposite side of the light energy conversion layer from the light energy conversion elements, i.e. on the backside of the light energy conversion layer. In this case, it is advantageous to align the light emitting elements with the light energy conversion elements in order to minimize shading on the transparent light energy conversion layer. As mentioned above, providing the optomechanical system with light emitting elements located on the backside of the light energy conversion layer permits to deliver light onto plants or into buildings in the absence of sunlight, for instance at night or on cloudy day or to provide additional light to the plants within a specific spectral band, optimized for their growth.

In a further preferred embodiment of the present invention, quaternary optical elements of refractive type and/or of reflective type are mounted directly onto the light emitting elements in order to direct the emitted light. With the quaternary optical elements it is possible to direct the light emitted by the light emitting elements and for instance to focus the emitted light onto plants which are placed below the system and are distant to each other. By this, the emitted light can optimally be used, for instance to promote plant growth. In case the light emitting elements are emitting light towards the optical arrangement, the quaternary optical elements can be used to direct the emitted light outside the optomechanical system, for instance to create lightning effects that can be desired when the system is used as billboard.

In yet another preferred embodiment of the present invention, the optical arrangement comprises a second optical layer that is bonded to the first optical layer either directly or by means of an adhesive layer. The second optical layer can for instance comprise further optical elements in order to better direct the highly-directional component of the incident light onto the light energy conversion layer.

In a further preferred embodiment of the present invention, the second optical layer is placed on top of the first optical layer in the direction of the source of incident light. In this embodiment, the second optical layer can protect the first optical layer against environmental conditions. Advantageously, the second optical layer has the form of rigid plate, for instance a glass plate.

In a further preferred embodiment of the present invention, the first optical layer and the second optical layer form a first hermetic space. This is advantageous since the first optical layer is better protected against environmental conditions, in particular against humidity. Moreover, this is advantageous in order to use the optical arrangement as a double-glazed window providing thermal insulation, for instance when the optomechanical system is used as a skylight, windows, or façade element or as greenhouse windowpane.

In a further preferred embodiment of the present invention, the first optical layer comprises a first optical sub-layer and a second optical sub-layer, wherein the first optical sub-layer and the second optical sub-layer are separated by a third optical layer that is bonded to the first optical sub-layer and to the second optical sub-layer either directly or by means of an adhesive layer. This allows to have a rigid third optical layer, made out of glass for instance, to structure the optical arrangement and a more flexible first optical layer, made out of, for instance, a polymer, such as silicone rubber, moulded or cast to a complex optical shape, for instance by injection moulding. Both first optical layer and third optical layer are then glued or bonded together to form a rigid structure capable of directing the highly-directional component of the incident light onto the light energy conversion elements.

In another preferred embodiment of the present invention, the optical arrangement comprises a fourth optical layer that is bonded to the first optical layer either directly or by means of an adhesive layer, wherein the fourth optical layer is placed on top of the first optical layer in the direction of the light energy conversion layer. With this, the optomechanical system can be used as a triple-glazed window and allows for further thermal insulation capability of the optomechanical system.

In yet another preferred embodiment of the present invention, the first optical layer and the fourth optical layer form a second hermetic space. This is advantageous since the optical arrangement is better protected against environmental conditions in particular against humidity. Furthermore, it allows for a better thermal insulation and therefore more efficient triple-glazed windows can be manufactured with the optomechanical system.

In yet another preferred embodiment of the present invention, the first hermetic space and/or the second hermetic space is filled by an inert gas, as for instance argon, helium, neon, radon, xenon, krypton or a combination thereof. This advantageous when using the optomechanical system as double-glazed or triple-glazed window since it improves the thermal insulation capability of the system without diminishing the energy conversion capability.

In a further preferred embodiment of the present invention, the second optical layer, the third optical layer and/or the fourth optical layer is made out of a rigid material, such as glass or acrylic (PMMA). This allows for increasing the rigidity of the optical arrangement and protect the subsequent optical layers from mechanical shocks or environmental pollution, such as dust or humidity. The second optical layer is typically flat, i.e. without optical elements, but it can be also patterned to alter the path or distribution of light. Furthermore, the front optical layer can be coated with a single- or double-sided anti-reflective coating to improve light transmission.

In a further preferred embodiment of the present invention, the first optical layer, the second optical layer, the third optical layer and/or the fourth optical layer is formed by molding, in particular by injection or compression molding. Molding is a particular simple and cheap method for producing the optical layers while allowing for a high optical precision.

In another preferred embodiment of the present invention, the first optical layer is made of a flexible material, such as silicone rubber. By using a flexible material, it is particularly simple to pattern the first optical layer and to form the primary optical elements.

In a further preferred embodiment of the present invention, the number of primary optical elements is equal to the number of light energy conversion elements. With this, there is a one-to-one relationship between the primary optical elements and the light energy conversion elements. This permits for converting a maximum of the light energy of the highly-directional component of the incident light.

In a further preferred embodiment of the present invention, the number of primary optical elements is bigger than the number of light energy conversion elements. This allows for transmitting a portion of the highly-directional component of the incident light through the system. This is advantageous in applications where a higher amount of transmitted light is required.

In a further preferred embodiment of the present invention, the light energy conversion layer comprises a plurality of light shaping elements, wherein the light shaping elements are positioned between the light energy conversion elements and are configured to modify the path of the light impinging on them. By means of the light shaping elements, it is possible to increase the divergence angle of the focused highly-directional component of incident light impinging on a region of the light energy conversion layer not covered by a light energy conversion element. This is advantageous when the optomechanical system is misaligned in order to control the intensity, direction and/or divergence of the light transmitted through the optomechanical system.

In another preferred embodiment of the present invention, the light energy conversion layer comprises a plurality of light diffusing elements, wherein the light diffusing elements are positioned between the light energy conversion elements and have transmissivity factors different from the light conversion layer. By means of the light diffusing elements with various degrees of transmissivity that are different from the light energy conversion layer it is possible to control the degree of transmissivity of the beam of direct light focused by the optical layer. Thanks to the shifting mechanism, the focused light can be targeted onto one or none of the light diffusing elements, in order to transmit light with a controlled degree of transmissivity.

In a further preferred embodiment of the present invention, the optomechanical system comprises one or more sliders, arranged between the light energy conversion layer and the optical arrangement, and one or more pre-constraining elements. The one or more slider can be fixed on either of its ends and sliding on the other, or it can be arranged to slide on both ends. For instance, the sliders can be fixed to the optical arrangement on one end and sliding on the light energy conversion layer on the other end, or vice-versa. A pre-constraining element, such as a spring, can be arranged on the same axis as the sliders, to ensure that the sliders are always in contact with the surface they are sliding on. With an appropriate number of sliders, the distance between the optical arrangement and the light energy conversion layer can be accurately and reliably preserved over the whole surface of the optomechanical system. Furthermore, the rigidity of the optomechanical system on the axis perpendicular to the surface of the optical arrangement is greatly increased, lowering the rigidity requirements on other guiding elements of the shifting mechanism.

In a further preferred embodiment of the present invention, the optomechanical system comprises sliding pads between a slider and a surface they are sliding on. With the sliding pads, it is possible to reduce friction and/or to locally change the slope of the surface on which the sliding occurs. More specifically, the sliding pads can have any desired curvature, for instance a portion of sphere, in such a way that when the slider is moving laterally on the sliding pad, the distance between the optical arrangement and the light energy conversion layer is changing according to the desired curvature. Otherwise said, a lateral displacement induces a controlled vertical displacement. This configuration is advantageous to increase the efficiency and/or the angular acceptance of the optomechanical system.

In yet another preferred embodiment of the present invention, the translation element of the shifting mechanism comprises at least one actuator and a control system such that the optical arrangement or the light energy conversion layer can be moved in one or more degrees of freedom in a translational movement. The translational movement may be configured in one, two or three degrees of freedom accordingly. Higher degree of freedom in translation allows for increasing the accuracy and sensitivity of the system, so that the energy conversion yield of the system can be maximized.

In a further preferred embodiment of the present invention, the shifting mechanism comprises two or more actuators disposed in parallel to the same translational axis but at opposite ends of the translation element and one or more actuators disposed in a direction perpendicular to the first two. This configuration allows for canceling any parasitic rotation of the translation element around an axis normal to the optical arrangement, in order to ensure that there is no relative rotation between the light energy conversion layer and the optical arrangement.

According to one preferred embodiment of the present invention, the actuator is an electro-mechanical actuator, an electro-static actuator, a piezo-electrical actuator, a stick-slip actuator or a pneumatic actuator.

In a further preferred embodiment of the present invention, the optomechanical system of the invention further comprises a feedback control loop to monitor the position of the translation element and/or the output power of the optomechanical system, wherein the feedback control loop is for example an optical sensor, a magnetic sensor or a photovoltaic sensor, a power meter or a combination of several of these sensors. The one or more sensors can report information on the relative or absolute position of the translation element, the optical arrangement, or the light energy conversion layer, or a combination thereof, or on the output power of the system such that the light energy conversion yield can be optimized. One or more sensors can also be provided to measure the amount of light transmitted through the optomechanical system and for instance arriving at plants placed below the system.

In another preferred embodiment of the present invention, a flexible membrane seals the gap between the translation element and the frame while allowing the translational element to move both laterally and vertically. In this configuration, the gap between the light energy conversion layer and the frame is sealed, which permits to protect the optical arrangement against environmental conditions while ensuring that light can be transmitted through the optomechanical system.

In a further preferred embodiment of the present invention, the light energy conversion elements are interconnected by connection lines provided on the light energy conversion layer, wherein the connection lines are made out of a transparent conductive material, such as a transparent conductive oxide. This embodiment is advantageous to guarantee that the light absorbed by the connection lines is minimal and to ensure that the maximum of light not captured by the light energy conversion elements is transmitted through the optomechanical system.

In a further preferred embodiment of the present invention, tertiary optical elements are provided on top of the light energy conversion layer in direction of the optical arrangement, wherein tertiary optical elements are configured such that the amount of light impinging on the connection lines is minimized. The tertiary optical elements allow for instance to modify the path of the light that otherwise would impinge on the connection lines of the light energy conversion elements and thus would be lost. Thanks to the tertiary optical elements, this light is redirected and transmitted through the optomechanical system.

In another preferred embodiment of the present invention, the optomechanical system comprises several optical arrangements, and several light energy conversion layers, wherein the shifting mechanism is configured such that it can move all optical arrangements relative to all light energy conversion layers or vice versa.

In yet another preferred embodiment of the present invention, the optomechanical system is arranged to be attached to a single-axis or dual-axis tracker. This allows for maximizing energy production and/or bringing the optomechanical system in a preferred position, for instance the vertical position, to increase the space for agricultural machines.

In a second aspect, the present invention relates to a method for converting or transmitting a highly-directional component of incident light and for transmitting a diffuse component of incident light with an optomechanical system according to the present invention, comprising the steps of:
▪ directing the highly-directional component of incident light onto light energy conversion elements;
▪ converting the energy of the light directed onto the light energy conversion elements into an output energy;
▪ transmitting the diffuse component of incident light through the optomechanical system;
▪ moving the optical arrangement relative to the light energy conversion layer or vice versa,
wherein the shifting mechanism moves the optical arrangement or the light energy conversion layer translationally by one or more translation element in such a way that the total output energy power of the light energy conversion elements and/or the amount of light transmitted through the optomechanical system is adjusted.

Thanks to this method, it is possible to efficiently convert light energy of the highly-directional component of the incident light while transmitting trough the optomechanical system the diffuse component of the incident light. The converted light is then used for the production of energy by the optomechanical system while the transmitted diffuse light is available for instance for illuminating plants placed below the system and therefore to enable their growth or for providing light in a building when the optomechanical system is used as a window, skylight or façade component. The shifting mechanism of the optomechanical system can be used to move either the optical arrangement or the light energy conversion layer in order to modulate and control the amount of light energy converted by the light energy conversion elements and the amount of light transmitted through the system. In particular, with the shifting mechanism it is possible to compensate for the movement of the sun relative to the optomechanical system during the day and to place the light energy conversion elements always at the most favorable position relative to the primary optical elements of the optical arrangement to maximize the production of energy.

In a third aspect, the present invention relates to the use of an optomechanical system according to the present invention to convert light energy of the highly-directional component of incident light coming from the sun and to transmit the diffuse light component of the incident light to agricultural goods, such as plants.

In a fourth aspect, the present invention relates to the use of an optomechanical system according to the present invention as a window, skylight, and/or façade component.

### Brief description of the drawings

The foregoing and other objects, features and advantages of the present invention are apparent from the following detailed description taken in combination with the accompanying drawings in which:
Fig. 1A illustrates a first embodiment of the use of an optomechanical system according to the present invention for agricultural application;
Fig. 1B illustrates a second embodiment of the use of an optomechanical system according to the present invention for agricultural application;
Fig. 1C illustrates a third embodiment of the use of an optomechanical system according to the present invention for a building integrated photovoltaic (BIPV) application;
Fig. 2A is a schematic cross-sectional view of the optomechanical system according to a first embodiment of this aspect of the present invention, where highly-directional light is impinging at normal incidence angle onto the optical arrangement;
Fig. 2B is a schematic cross-sectional view of the optomechanical system according to a first embodiment of this aspect of the present invention, where highly-directional light is impinging at a non-normal incidence angle onto the optical arrangement;
Fig. 3 is a schematic cross-sectional view of the optomechanical system according to the first embodiment of this aspect of the present invention, where the light energy conversion layer is intentionally misaligned in order to transmit highly-directional light;
Fig. 4 is a schematic top view of the optical arrangement according to a second embodiment of this aspect of the present invention, wherein the primary optical elements have a hexagonal contour;
Fig. 5 is a schematic cross-sectional view of the optical arrangement according to a third embodiment of this aspect of the present invention;
Fig. 6 is a schematic cross-sectional view of the optical arrangement according to a fourth embodiment of this aspect of the present invention;
Fig. 7 is a schematic cross-sectional view of the optical arrangement according to a fifth embodiment of this aspect of the present invention;
Fig. 8 is a schematic cross-sectional view of the optical arrangement according to a sixth embodiment of this aspect of the present invention;
Fig. 9A is a schematic cross-sectional view of the light energy conversion layer according to a seventh embodiment of this aspect of the present invention;
Fig. 9B is a schematic cross-sectional view of the light energy conversion layer according to an eighth embodiment of this aspect of the present invention;
Fig. 9C is a schematic cross-sectional view of the light energy conversion layer according to a ninth embodiment of this aspect of the present invention;
Fig. 9D is a schematic cross-sectional view of the light energy conversion layer according to a tenth embodiment of this aspect of the present invention;
Fig. 10 is a schematic cross-sectional view of the light energy conversion layer according to a eleventh embodiment of this aspect of the present invention;
Fig. 11 is a schematic cross-sectional view of the light energy conversion layer according to a twelfth embodiment of this aspect of the present invention;
Fig. 12 is a schematic cross-sectional view of the light energy conversion layer according to a thirteenth embodiment of this aspect of the present invention;
Fig. 13 is a schematic cross-sectional view of the light energy conversion layer according to a fourteenth embodiment of this aspect of the present invention;
Fig. 14 is a schematic cross-sectional view of the light energy conversion layer according to a fifteenth embodiment of this aspect of the present invention;
Fig. 15 is a schematic cross-sectional view of the light energy conversion layer according to a sixteenth embodiment of this aspect of the present invention;
Fig. 16 is a schematic cross-sectional view of the optical arrangement and the light energy conversion layer according to a seventeenth embodiment of this aspect of the present invention;
Fig. 17 is a schematic top view of an optomechanical system according to an eighteenth embodiment of the present invention;
Fig. 18 is a schematic top view of an optomechanical system according to a nineteenth embodiment of the present invention;
Fig. 19A is a schematic cross-sectional view of the optomechanical system according to a twentieth embodiment of this aspect of the present invention, where the light energy conversion layer is in its standard position;
Fig. 19B is a schematic cross-sectional view of the optomechanical system according to the twentieth embodiment of this aspect of the present invention, where the light energy conversion layer is in a shifted position;
Fig. 20 is a schematic cross-sectional view of the optical arrangement and the light energy conversion layer according to a twenty-first embodiment of this aspect of the present invention;
Fig. 21 is a schematic cross-sectional view of the optomechanical system according to a twenty-second embodiment of this aspect of the present invention;
Fig. 22 is a schematic cross-sectional view of the optomechanical system according to a twenty-third embodiment of this aspect of the present invention; and
Fig. 23 is a schematic cross-sectional view of the optomechanical system according to a twenty-fourth embodiment of this aspect of the present invention.

### Detailed description of the preferred embodiments of the invention

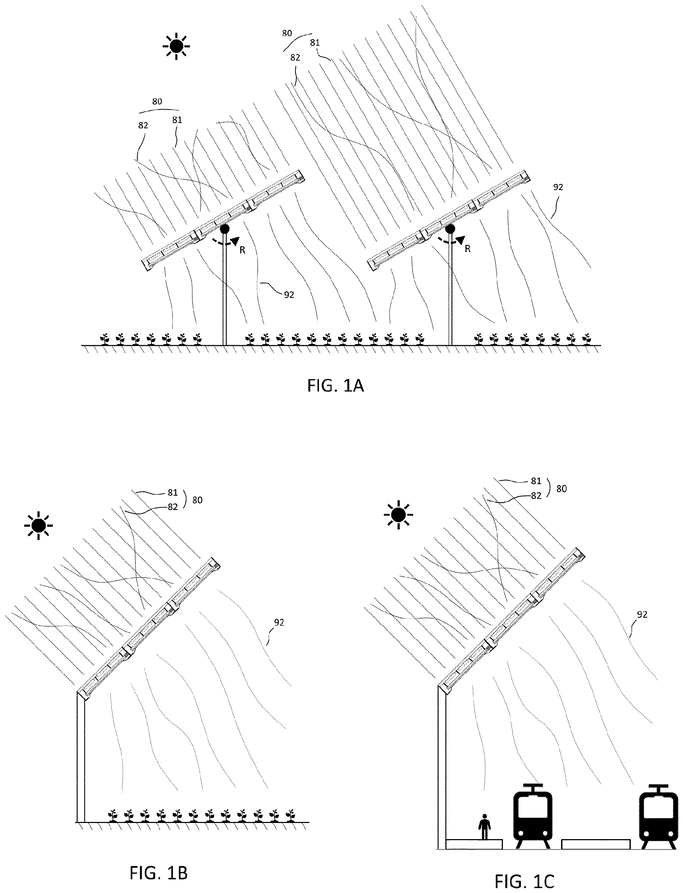

Figures 1A and 1B illustrate a first and second embodiment of the use of an optomechanical system 1 according the present invention for agricultural application. The general principle of the present invention is to provide an optomechanical system that permits to collect with high efficiency the highly-directional light component 81, i.e. the collimated light, of the entire incident light 80 coming from a light source, as for instance the sun, while transmitting the diffuse light component 82 of the incident light 80 to objects placed beyond the optomechanical system, here plants. As will be explained in details below the optomechanical system 1 is configured such that the light energy from the highly directional incident light 81 arriving "directly" from the sun is converted by PV cells while the diffuse incident light 82 is transmitted through the optomechanical system, allowing the transmitted diffuse light 92 to arrive at the plants placed below the optomechanical system. The optomechanical system further comprises a shifting mechanism (not shown in Figures 1A and 1B) that permits to maximise to light energy conversion whatever position of the sun in the sky. As can be seen in these figures, the optomechanical system can be mounted on a pole either on the side of the system or in the middle. As explained in details below, thanks to the shifting mechanism of the optomechanical system 1, the tilt angle to the system 1 relative to the ground does not necessarily need to be changed during the day. Figure 1A illustrates also that the optomechanical system can be mounted on a single-axis tracker, with rotating axis R, in order to maximize energy production or put the optomechanical system in a vertical position to increase the space for agricultural machines.

In the field of agriculture, the optomechanical system allows therefore transmitting diffuse light to plants placed below the optomechanical system and therefore permits the growth of these plants. Important to note that even if Figures 1A and 1B illustrate the application of optomechanical systems according to the present invention in the agriculture field, the systems can be used in several other fields, as for instance in the field of Building Integrated Photovoltaics (BIPV) as depicted in Figure 1C.

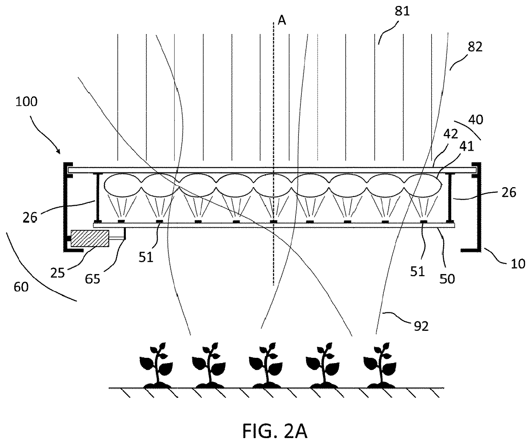

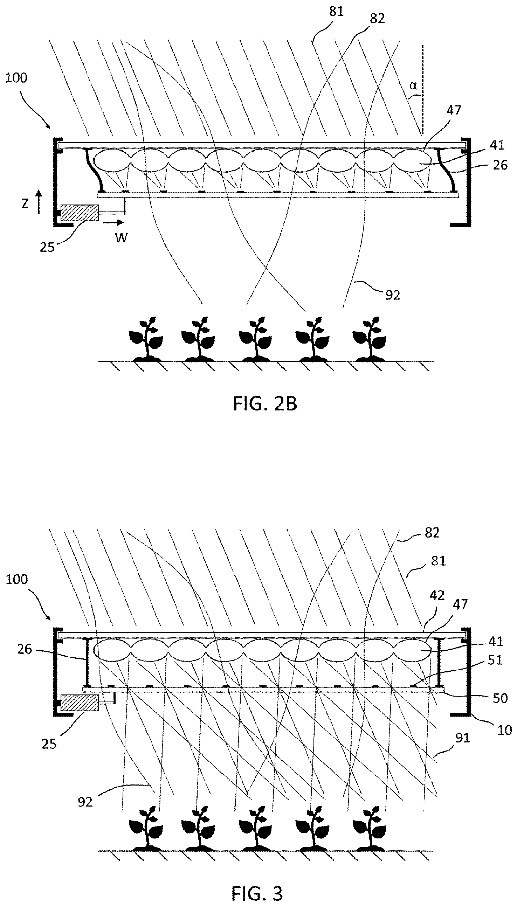

Figures 2A and 2B display a photovoltaic optomechanical system 100 according to first embodiment of the present invention. The optomechanical system 100 comprises an optical arrangement 40 that comprises at least one first optical layer 41 designed to direct the highly-directional component 81 of the incident light 80 onto the light energy conversion elements 51 placed on a transparent or translucent light energy conversion layer 50, a static frame 10 to which the optical arrangement 40 is attached and a shifting mechanism 60, arranged to move the optical arrangement 40 relatively to the static frame 60, so that the amount of light energy converted by the light energy conversion layer 50 and the amount of transmitted light 92 through this layer can both be adjusted, depending on the relative position of the optical layer 40 and the light energy conversion layer 50. As can be seen in these Figures, the optical layer 40 and the light energy conversion layer 50 are connected together by guiding elements 26, which are in this particular embodiment flexible guiding elements. The guiding elements 26, an actuator 25, and a shifting element 65 are parts of the shifting mechanism 60. The aim of the shifting mechanism 60, and especially of the guiding elements 26, the actuator 25 and of the translation element 65, is to move the light energy conversion layer 50 while allowing only translation along the direction W. In particular, the shifting mechanism 60 is configured such that it forbids any relative rotation, around an axis Z perpendicular to the plane of the optomechanical system, between the optical arrangement 40 and the light energy conversion layer 50. Important to note is that even if in Figures 2A and 2B the light energy conversion layer 50 is movable relative to the frame 10 and the optical arrangement 40 fixed, the optomechanical system according to the present invention could provide for a movable optical arrangement 40 and a fixed light energy conversion layer 50. Moreover, in the embodiment presented in Figures 2A and 2B the optical arrangement 40 comprises besides the first optical layer 41, that is configured to direct the collimated incident light 81, a second optical layer 42. In this embodiment, the second optical layer 42 takes the form of a rigid transparent plate, for instance a glass plate, that is mainly foreseen to protect the first optical layer 41 against environmental conditions.

As depicted in Figure 2A when the incidence of direct sunlight is normal to the plane of the optomechanical system 100. The optical arrangement 40, here the first optical layer 41, concentrates and transmits the highly-directional component 81 of the incident light 80 to the light energy conversion elements 51, while diffuse incident 82 is transmitted through the light energy conversion layer 50 allowing transmitted light 92 to arrive at the plants placed below the optomechanical system 100.

In comparison, Figure 2B illustrates the optomechanical system 100 when the highly-directional component 81 of the incident light 80 impinges on the system at a larger incidence angle α, corresponding to a situation when the sun has moved in the sky during the day. Thanks to the shifting mechanism 60, when the highly-directional component 81 of the incident light 80 is still optimally directed onto the light energy conversion elements 51, while diffuse incident light 82 goes through the system to the plants placed below the optomechanical system 100. Thanks to the guiding elements 26, the light energy conversion layer 50 is not only moved in translation in direction W but also in a direction parallel to the axis Z (see Figure 2B). By this, the light energy conversion elements 51 can be located at the focal point of the focusing elements of the first optical layer 41 independently of the position of the source of incident light.

In Figure 3, the optomechanical system 100 is configured such that the shifting mechanism 60 intentionally misaligns the optomechanical system 100, in order to transmit direct the highly-directional component 81 of the incident light 80 through the system 100 such that not only diffuse transmitted light 82 but also highly-directional transmitted light 91 arrives at the plants below. This is advantageous when the plants require more irradiance than what diffuse sunlight 82 alone can provide over one day. For instance, the optomechanical system 100 can be configured to be misaligned in the early mornings or late afternoons, when the sun is low and the efficiency of light energy conversion would anyway decrease. More generally, the optomechanical system 100 can be configured to be misaligned at any time during the day, e.g. based on manual inputs or the feedback of a sensor measuring the amount of energy received by the plants (not shown here).

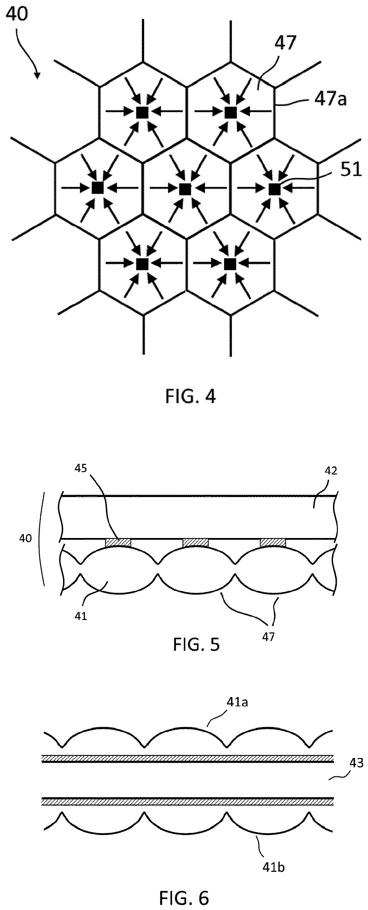

Figures 4 to 22 present different embodiments of the optical arrangement 40, the light energy conversion layer 50, and the shifting mechanism 60. Important to note, that these embodiments can be combined to form further embodiments in the frame of the present invention.

As illustrated in Figure 4, the first optical layer 41 of the optical arrangement 40 of an optomechanical system according to the present invention can comprise a plurality of primary optical elements 47, for instance be lenses or mirrors, that have advantageously a hexagonal contour 47a. By this, the primary optical elements 47 can be arranged side-by-side and cover the entire surface of the first optical layer 41 of the optical arrangement 40 without any gaps.

Figure 5 illustrates another embodiment of the present invention where the optical arrangement 40 is composed of first and second optical layers 41 and 42 that are attached together. The first and second optical layers 41, 42 can be either directly bonded together, for instance by casting or overmolding processes, or using a plasma activation process (not shown here). The two optical layers 41, 42 can also be bonded together by means of an intermediate adhesive layer 45, as for example silicone glue or UV cured acrylic glue, as depicted in this Figure. The second optical layer 42 is advantageously highly rigid to structure the optical arrangement 40 while a more flexible first optical layer 41, for instance made out of a polymer such as silicone rubber or PMMA, is molded or cast to a complex optical shape, for instance by injection molding.

Figure 6 shows a further embodiment of the present invention in which the first optical layer 41 of the optical arrangement 40 is composed of a first optical sub-layer 41a and a second optical sub-layer 41b. The first and second optical sub-layers 41 and 41b are advantageously made of a polymer such as silicone rubber, overmolded or bonded on both faces of a third optical layer 43 which is formed as a rigid transparent substrate made for instance out of glass.

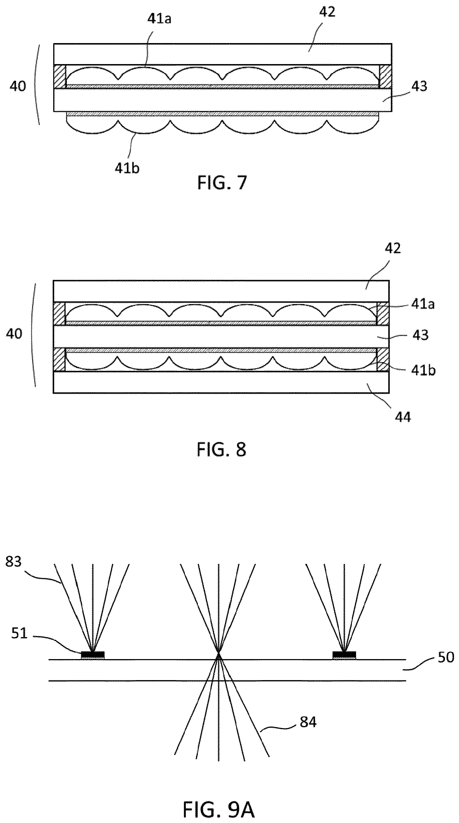

The optical arrangement 40, of the embodiment presented in Figure 7, comprises a first optical sub-layer 41a, a second optical sub-layer 41b, a second optical layer 42 and a third optical layer 43. Two layers 41 a and 41b are made out of a polymer overmolded or bonded on both sides of the rigid third optical layer 43 and attached to another rigid second optical layer 42 on the front side. The space within the two rigid second and third optical layers 42 and 43 can advantageously be hermetically sealed and filled with an inert gas, such as argon, helium, neon, krypton, xenon, radon or a combination thereof. This is beneficial in order to use the optical arrangement 40 as a double-glazed window providing thermal insulation, for instance when the optomechanical system is used as a skylight, window, façade element or greenhouse windowpane. Similarly and as shown in Figure 8, the optical arrangement 40 can be configured as a triple-glazed window. To this aim, a rigid fourth optical layer 44 is added on the backside of the optical arrangement 40 presented in Figure 7. This is advantageous to add further thermal insulation capability to the optomechanical system.

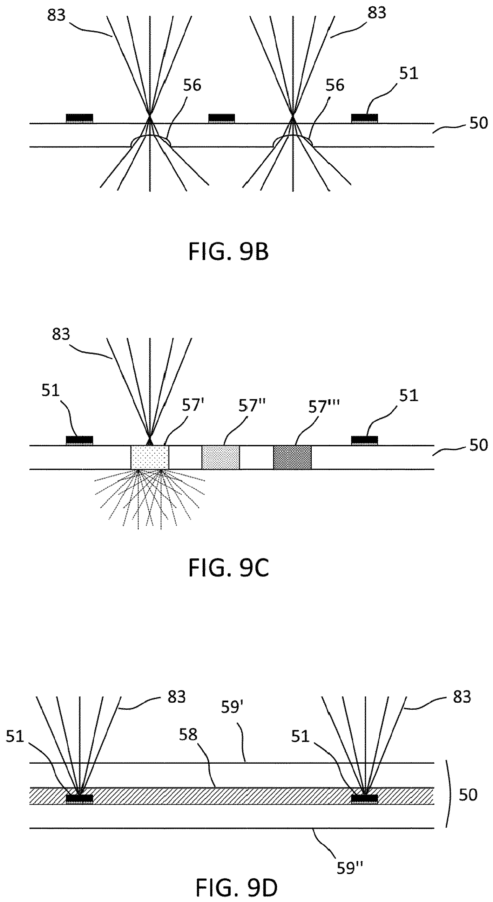

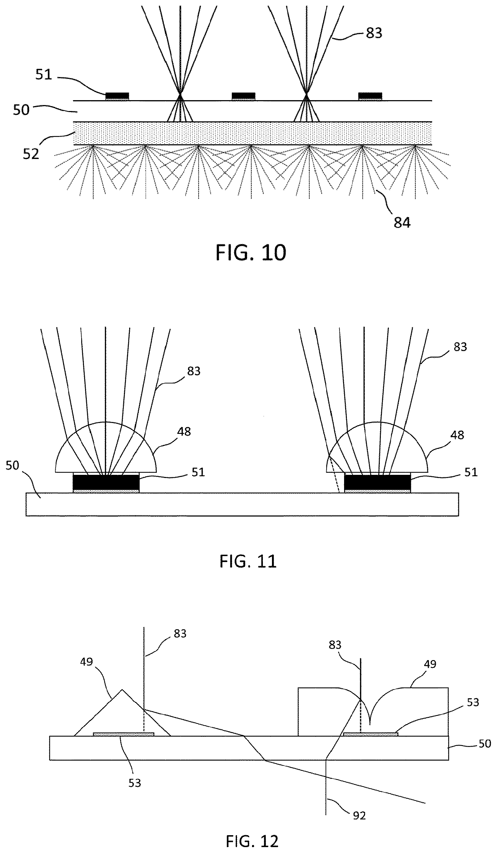

Figure 9A illustrates a further preferred embodiment of the present invention. In this embodiment, the light energy conversion layer 50 comprises a plurality of light energy conversion elements 51, wherein the number of light energy conversion elements 51 is purposely chosen smaller than the number of primary optical elements 47 in the optical arrangement 40. By this an optomechanical system with higher light transmission capability can easily be manufactured. As explained below, this is particularly advantageously when the light energy conversion layer 50 of the embodiment presented in Figure 9A is combined with one of the elements shown in Figures 9B, 9C, 9D and 10.

In Figure 9B, light shaping elements 56 are machined into the light energy conversion layer 50 in order to achieve some desired optical effects, such as increasing the divergence angle of the focused highly-directional component of incident light 83 impinging on a region of the light energy conversion layer not covered by a light energy conversion element 51. This is advantageous when the optomechanical system is misaligned in order to control the intensity, direction and/or divergence of the light transmitted through the optomechanical system.

In Figure 9C, several light diffusing elements 57', 57" and 57'" with various degrees of transmissivity are integrated into the light energy conversion layer 50. This is advantageous in order to control the degree of diffusivity of the beam of direct sunlight focused by the optical layer 40. Thanks to the shifting mechanism 60, the focused light 83 can be targeted onto one or none of the light diffusing elements 57', 57" and 57", in order to transmit light with a controlled degree of transmissivity.

In Figure 9D the primary light energy conversion elements 51 are encapsulated by encapsulating layer 58, made for instance out of ethylene-vinyl acetate (EVA), or poly-ethylene-vinyl acetate (PEVA). The encapsulating layer 58 is sandwiched between a first protective layer 59' of the light energy conversion layer and a second protective layer 59", the two protective layers 59' and 59" being transparent or translucent. This is advantageous to protect the light energy conversion elements from stress and contaminants, such as humidity, dust, etc. The two protective layers 59' and 59" can advantageously be made of glass for its rigidity and resistance to shocks. Alternatively, they can be made of a polymer such as PET to make a more lightweight optomechanical system.

In Figure 10, a further embodiment of the present invention is depicted. This embodiment is similar to the embodiment shown in Figure 9 but a light scattering layer 52, for instance in form of a translucent substrate, has been added below the light energy conversion layer 50. This allows to diffuse focused highly-directional component of incident light 83 in case of misalignment between optical arrangement 40 and light energy conversion layer 50, or when the number of light energy conversion elements 51 is purposely chosen smaller as the number of primary optical elements 47, and to provide a homogeneous aspect when the optomechanical arrangement is viewed from the light scattering layer 52 side. As can be seen in Figure 10, the aim of the light scattering layer 52 is to homogenize the illuminance and to hide small features from view. This permits to make the optomechanical system more aesthetic, which is particularly advantageous for BIPV applications.

In yet another embodiment of the present invention displayed in Figure 11, secondary optical elements 48 are provided directly on the light energy conversion elements 51. The secondary optical elements 48 ensure a better collection of focused highly-directional component of incident light 83 by the light energy conversion elements 51. As shown in Figure 11, the secondary optical elements 48 increase in particular the alignment tolerance between the optical arrangement 40 and the light energy conversion layer 50. When several light energy conversion elements 51 are mounted on the same substrate, the light concentrated and transmitted 83 by each primary optical element 47 of the optical arrangement 40 can be slightly misaligned, as illustrated on the right side of Figure 11. The secondary optical elements 48 allow therefore for minimizing the losses related to the mentioned possible misalignment.

Figure 12 shows another embodiment of the present invention. Here, tertiary optical elements 49 are arranged on top of opaque structures 53 provided on the light energy conversion layer 50. The tertiary optical elements 49 are configured to modify the path of transmitted light 83 such that it does not impinge on an opaque but not energy producing area of the light energy conversion layer 50 and to ensure optimal transmission through the optomechanical system. Examples of opaque structures 53 include some connection lines provided to electrically interconnect the light energy conversion elements 51 in form of PV cells, or pads on which the light energy conversion elements 51 or other electrical components are assembled. Tertiary optical elements 49 of reflective or refractive type can be used to "mask" these opaque structures and improve transmission of transmitted light 83 through the light energy conversion layer 50.

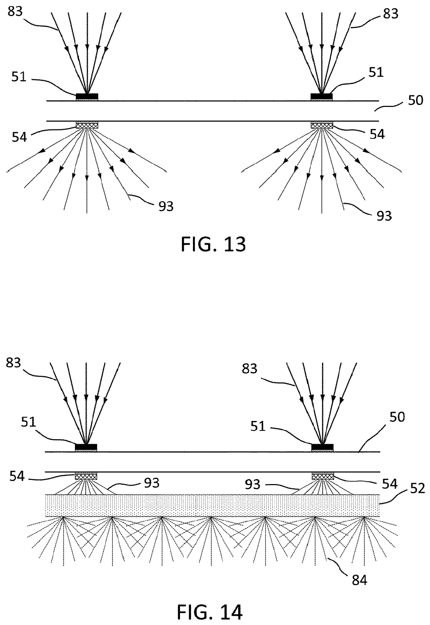

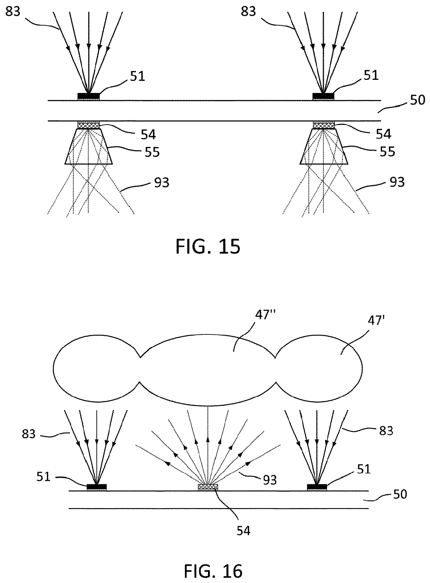

As shown in Figures 13 to 15 the light energy conversion layer 50 can comprise light emitting elements 54. In the embodiments of these Figures, the optomechanical system can be used as a lighting fixture, which is advantageous in various scenarios. For instance in case the optomechanical system is installed above agricultural land, the light emitting elements 54 can provide light to the plants in the absence of sunlight, for instance at night or on cloudy days, or provide additional light within a specific spectral band (such as blue-shifted light below 450nm or red-shifted light above 650nm), optimized for the plants being grown and their stage of growth. In case the optomechanical system is installed as a skylight, the light emitting elements can provide lighting inside the building when natural sunlight is not sufficient, for instance at night or on cloudy days. Alternatively, by mounting the light emitting elements 54 on the same side of the substrate as the light energy conversion elements 51, as in the embodiment presented in Figure 16, it is possible to emit light towards the outside of the building, and be used for architectural lighting, street lighting or advertisement.

The light emitting elements 54 can be advantageously light emitting diodes, which can be placed on the front side in-between light energy conversion elements 51, as shown in Figure 16, or be placed on the backside as shown in Figures 13 to 15. It can be advantageous to align the light emitting elements 54 with the light energy conversion elements 51, as shown in Figures 13 to 15, in order to minimize shading on the transparent substrate. As illustrated in Figure 14, an additional light scattering layer 52 can be foreseen to homogenize the output of the light emitting elements 54. Alternatively, as illustrated on Figure 15, quaternary optical elements 55 can be mounted on the light emitting elements 54 to direct the light output of these elements. Advantageously, the quaternary optical elements 55 are in the form of collimators to collimate the light output of the light emitting elements 54.

As illustrated in Figure 16, the optical arrangement 40, more precisely the first optical layer 41, can comprise an array of heterogeneous primary optical elements 47, with different optical shapes when facing the light energy conversion elements 51 or the light emitting elements 54.

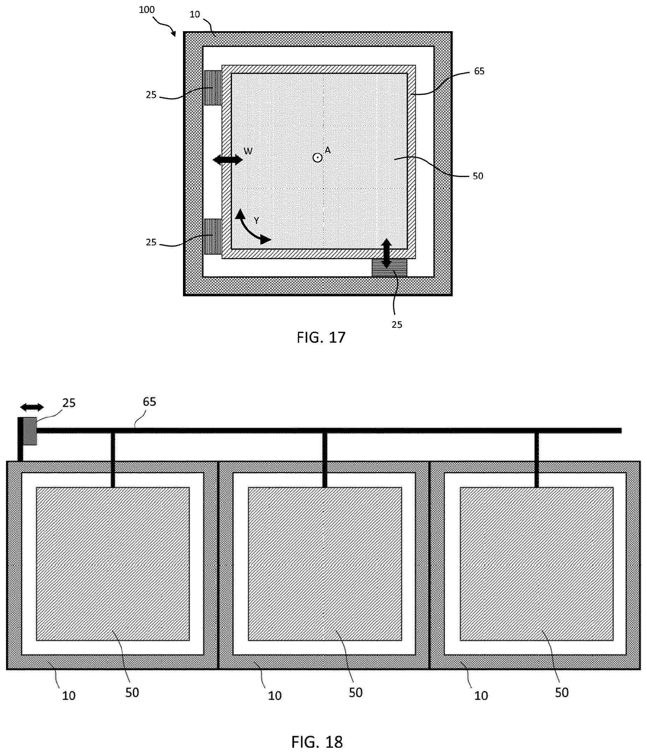

Figure 17 illustrates that, according to a further embodiment of the present invention, the shifting mechanism 60 comprises three shifting elements 25 here in the form of actuators 25, two of which are disposed in parallel on the same axis W but at opposite ends of the translation element 65, here in the form of a frame around the optical arrangement 40, and a third one in a direction normal to the first two. This configuration permits to control and cancel any parasitic rotation Y of the translation element 65 around the axis A.

It goes without saying that the shifting mechanism 60 as shown in all embodiments of the present invention is capable of moving either the optical arrangement 40 or the light energy conversion layer 50 translationally in one, two or three degrees of freedom relative to the frame element 10, thereby enabling the primary optical elements 47 to optimally direct the highly-directional component 81 of the incident light 80 onto the light energy conversion elements 51.

The different configurations of the present invention allow the translation element 65 of the optomechanical system to perform only small strokes, ranging from for example from a few micrometers to a few centimeters. Such displacements are typically at least two orders of magnitude smaller than the outer size of the optomechanical system. The displacements could be for example of the same order of magnitude as the size of the primary optical elements 47. The displacements are limited to translational movements along one, two or three axes (with one, two or three degrees of freedom). Rotations are blocked or cancelled by means of a specific disposition of the guiding elements 26 combined with an arrangement of one or more actuator 25.

As illustrated in Figure 18, several optomechanical systems can be combined together, wherein one actuator 25 and one shifting element 65 are configured in such manner that the optical arrangements 40 of all the optomechanical systems can be translated at the same time.

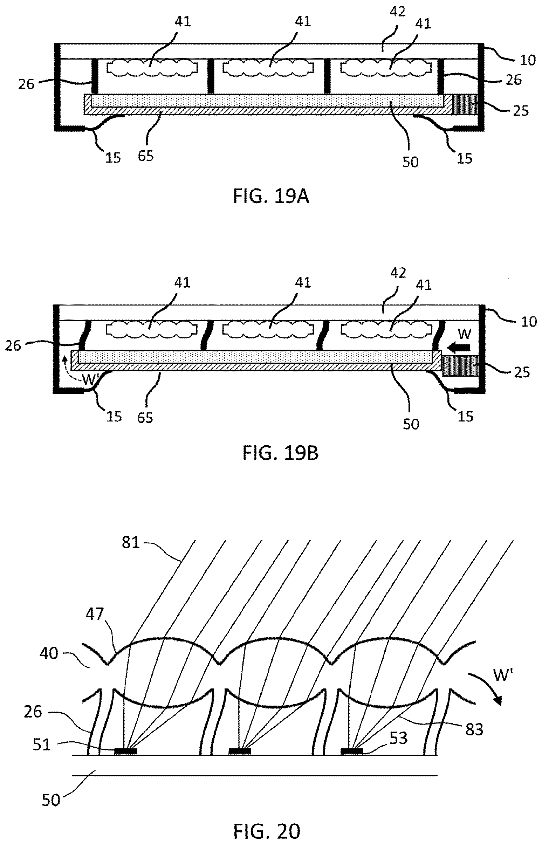

According to another embodiment of the present invention, illustrated in Figures 19A and 19B, the light energy conversion layer 50 is directly attached to the optical arrangement 40 by means of several, here four guiding elements 26. In this case, the guiding elements 26 are advantageously flexible guiding elements such as leaf springs, or any suitable type of flexible elements such as double ball joints, double magnetic ball joints or double universal joints, such as double cardan joints. As illustrated in Figure 19B, the guiding elements 26 are designed in such a way that when the actuator 25 pushes or pulls the translation element 65 in the direction W, the light energy conversion layer 50, mounted on the translation element 65, moves along a curved trajectory W', for instance a portion of a paraboloid or a spherical trajectory. In other words, the guiding elements 26 transform the linear movement of the actuator 25 into a curved movement of the translation element 65. Of course and in order to be able to transmit diffuse light to objects, for instance to plants, placed below the optical arrangement, the translation element 65 is transparent or is in a form of a scattering layer 52 as presented for instance in Figure 10.

In the embodiment of Figures 19A and 19B, the frame 10 is at least partially open at the bottom and a flexible membrane 15 is provided between the static frame 10 and the shifting element 65. Of course, the flexible membrane 15 could also be provided between the static frame 10 and the light energy conversion layer 50. The flexible membrane 15 seals the gaps between the translation element 65 or the light energy conversion layer 50 and the frame 10, while allowing the translation element 65 to move both laterally and vertically. Thanks to the flexible membrane 15, the light energy conversion elements 51 (not shown in these figures) and the optical arrangement 40 are protected against environmental conditions in particular against humidity.

Figure 20 shows another embodiment of the present invention in which the flexible guiding elements 26 can be foreseen as integral parts of the optical arrangement 40. As illustrated in this Figure, the flexible guiding elements 26 can advantageously be designed such that the optical arrangement 40 is moved along a curved trajectory W' when the shifting mechanism 60 is actuated. The flexible guiding elements 26 can be attached to the light energy conversion layer 50 by various means, including gluing, clamping or direct molding onto the light energy conversion layer 50.

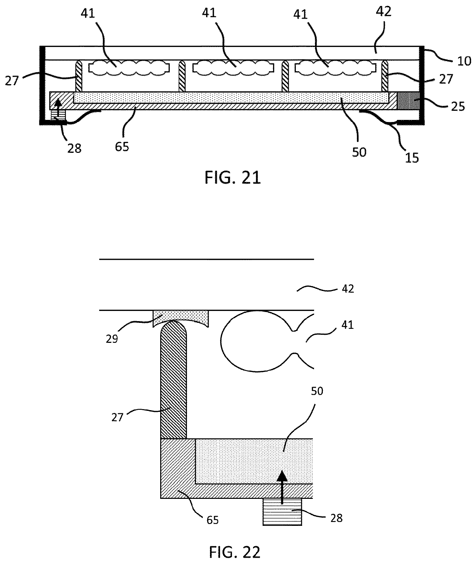

In another embodiment of the present invention illustrated in Figure 21, a plurality of sliders 27 are foreseen between the optical arrangement 40 and the light energy conversion layer to ensure, in combination with one or a plurality of pre-constraining elements 28, that the distance between the light energy conversion layer 50 and the optical arrangement 40 is constant over the whole optomechanical system. The pre-constraining elements 28 can for instance be springs or leaf springs. The number of sliders 27 is typically at least three in the direction of movement of the actuator 25 and increases with the size/surface of the panel. In order to accommodate a plurality of sliders 27, the first optical layer 41 of the optical arrangement 40 can be made of several blocks as illustrated in Figure 21.

The sliders 27 can slide directly on the surface of one of the layers of the optical system 1, i.e. either the optical arrangement 40 or the light energy conversion layer 50, if necessary with the addition of a coating to reduce friction, or according to a further embodiment of the present invention they can slide on flat or curved sliding pads 29, as shown in Figure 22. The curvature of the sliding pads 29 can be used to change the distance between the light energy conversion layer 50 and the optical arrangement 40 when the translation element 65 is moved laterally. This is advantageous since with the adaptation of the distance between the optical arrangement 40 and the light energy conversion layer 50, the light energy conversion elements 51 can be brought at the focal point of the primary optical elements 47.

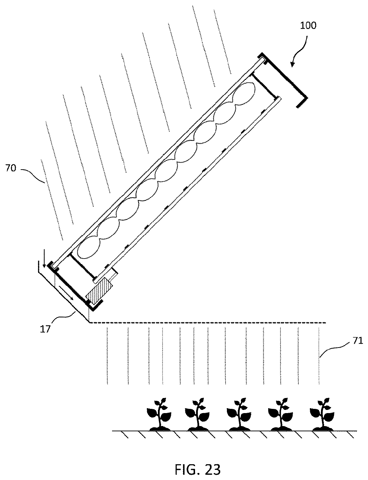

Figure 23 shows another embodiment of the present invention, where a gutter 17 is attached to the frame of the optomechanical system 100. The gutter collects rain 70 falling on the front surface of the optomechanical system and distribute collected water 71 to the plants below. This is advantageous to avoid depriving plants below the optomechanical system of rainwater and the need for artificial irrigation.

Although the present disclosure has been described with reference to particular means, materials and embodiments, one skilled in the art can easily ascertain from the foregoing description the essential characteristics of the present disclosure, while various changes and modifications may be made to adapt the various uses and characteristics as set forth in the following claims.

### Reference numbers

- 10: frame element
- 15: flexible membrane
- 17: gutter
- 25: actuator
- 26: guiding element
- 27: sliders
- 28: pre-constraining element
- 29: sliding elements
- 40: optical arrangement
- 41: first optical layer
- 42: second optical layer
- 43: third optical layer
- 44: fourth optical layer
- 45: adhesive layer
- 47: primary optical element
- 48: secondary optical element
- 49: tertiary optical element
- 50: light energy conversion layer
- 51: light energy conversion element
- 52: light scattering layer
- 53: connection lines
- 54: light emitting elements
- 55: quaternary optical elements
- 56: light shaping element
- 57',57",57''': light diffusing elements
- 58: encapsulating layer
- 59',59": first and second protective layers
- 60: shifting mechanism
- 65: translation element
- 70: rain
- 71: distributed water
- 80: incident light
- 81: highly-directional component of incident light
- 82: diffuse component of incident light
- 83: focused highly-directional component of incident light
- 90: transmitted light
- 91: highly-directional transmitted light
- 92: diffuse transmitted light
- 100: optomechanical system

## Claims

1. An optomechanical system (100) for converting or transmitting a highly-directional component (81) of incident light (80) and for transmitting a diffuse component (82) of incident light (80), comprising
▪ an optical arrangement (40) comprising a first optical layer (41), wherein the first optical layer (41) comprises a plurality of primary optical elements (47);
▪ a light energy conversion layer (50) at least partially transparent to light and comprising a plurality of distant light energy conversion elements (51) capable of converting light energy in an output energy;
▪ a shifting mechanism (60) for moving the optical arrangement (40) relative to the light energy conversion layer (50) or vice versa; and
▪ a frame element (10) to which either the optical arrangement (40) or the light energy conversion layer (50) is attached,
wherein the shifting mechanism (60) is arranged to displace the optical arrangement (40) or the light energy conversion layer (50) translationally relative to the frame element (10), through one or more translation element (65),
wherein the primary optical elements (47) of the first optical layer (41) and the shifting mechanism (60) are designed such that the highly-directional component (81) of incident light (80) is directable onto the light energy conversion elements (51) of the light energy conversion layer (50) and such that the diffuse component (82) of incident light (80) is transmittable through the regions of the light energy conversion layer (50) not covered by the light energy conversion elements (51), and
wherein the total output power of the light energy conversion elements (51) and/or the amount of light transmitted through the optomechanical system (100) is adjustable.

2. The optomechanical system (100) according to claim 1, wherein the shifting mechanism (60) is arranged to displace the optical arrangement (40) or the light energy conversion layer (50) in such a way that the total output energy power of the light energy conversion elements (51) can be maximized.

3. The optomechanical system (100) according to any one of the claims 1 or 2, wherein the shifting mechanism (60) comprises one or more guiding elements (26), such as double universal joints, for instance double cardan joints, double ball joints and/or one or more flexible guiding elements, such as a spring or leaf spring, in such a way that the one or more guiding elements (26) or flexible guiding elements are capable of limiting the degrees of freedom of the optical arrangement (40) and/or of the light energy conversion layer (50).

4. The optomechanical system (100) according to claim 3, wherein the one or more guiding elements (26) and/or the one or more flexible guiding elements are capable of suppressing any rotational movement between the optical arrangement (40) and the light energy conversion layer (50).

5. The optomechanical system (100) according to any one of the claims 3 or 4, wherein the light energy conversion layer (50) is directly attached to the optical arrangement (40) by means of the guiding elements (26) and/or the flexible guiding elements.

6. The optomechanical system (100) according to any one of the claims 3 to 5, wherein the guiding elements (26) and/or the flexible guiding elements are arranged to guide the movement of the optical arrangement (40) or the light energy conversion layer (50) on a paraboloid or on a spherical trajectory.

7. The optomechanical system (100) according to any one of the preceding claims, wherein the optomechanical system comprises a gutter (17) attached to the frame (10) for collecting rainwater falling on the optomechanical system (100).

8. The optomechanical system (100) according to claim 7, wherein the optomechanical system comprises a water distribution system for distributing the collected rainwater.

9. The optomechanical system (100) according to any one of the claims preceding claims, wherein the primary optical elements (47) are of reflective type such as mirrors or refractive type such as lenses including plano-convex, plano-concave, bi-convex, bi-concave, meniscus type and aspheric curvature having polynomial shape.

10. The optomechanical system (100) according to any one of the preceding claims, wherein the primary optical elements (47) have a hexagonal or rectangular tiling contour and are arranged in an array.

11. The optomechanical system (100) according to any one of the preceding claims, wherein the light energy conversion elements (51) are PV cells, for instance high-efficiency PV cells.

12. The optomechanical system (100) according to any one the preceding claims, wherein secondary optical elements (48) of refractive type and/or of reflective type are mounted directly onto the light energy conversion elements (51) in order to further focus the highly-directional component (81) of incident light (80) onto the light energy conversion elements (51).

13. The optomechanical system (100) according to any one of the preceding claims, wherein the light energy conversion layer (50) is encapsulated in an encapsulating layer (58) which is sandwiched between a first protective layer (59') and a second protective layer (59").

14. The optomechanical system (100) according to any one of the preceding claims, wherein a light scattering layer (52) is placed below the light energy conversion layer (50) in the direction opposite to the optical arrangement (40).

15. The optomechanical system (100) according to any one of the preceding claims, wherein light emitting elements (54) are provided on the light energy conversion layer (50).

16. The optomechanical system (100) according to claim 15, wherein the light emitting elements (54) are placed on the opposite side of the light energy conversion layer (50) from the light energy conversion elements (51).

17. The optomechanical system (100) according to any one of the claims 15 or 16, wherein quaternary optical elements (55) of refractive type and/or of reflective type are mounted directly onto the light emitting elements (54) in order to direct the emitted light.

18. The optomechanical system (100) according to any one of the preceding claims, wherein the optical arrangement (40) comprises a second optical layer (42) that is bonded to the first optical layer (41) either directly or by means of an adhesive layer (45).

19. The optomechanical system (100) according to claim 18, wherein the second optical layer (42) is placed on top of the first optical layer (41) in the direction of the source of incident light.

20. The optomechanical system (100) according to any one of the claims 18 or 19, wherein the first optical layer (41) and the second optical layer (42) form a first hermetic space.

21. The optomechanical system (100) according to any one of the preceding claims, wherein the first optical layer (41) comprises a first optical sub-layer (41a) and a second optical sub-layer (41b), wherein the first optical sub-layer (41a) and the second optical sub-layer (41b) are separated by a third optical layer (43) that is bonded to the first optical sub-layer (41a) and to the second optical sub-layer (41b) either directly or by means of an adhesive layer (45).

22. The optomechanical system (100) according to any one of the preceding claims, wherein the optical arrangement (40) comprises a fourth optical layer (44) that is bonded to the first optical layer (41) either directly or by means of an adhesive layer (45) and wherein the fourth optical layer (44) is placed on top of the first optical layer (41) in the direction of the light energy conversion layer (50).

23. The optomechanical system (100) according to claim 22, wherein the first optical layer (41) and the fourth optical layer (44) form a second hermetic space.

24. The optomechanical system (100) according to any one of the claims 20 or 23, wherein the first hermetic space and/or the second hermetic space is filled by an inert gas, as for instance argon, helium, neon, radon, xenon, krypton or a combination thereof.

25. The optomechanical system (100) according to any of the claims 18 to 24, wherein the second optical layer (42), the third optical layer (43) and/or the fourth optical layer (44) is made out of a rigid material, such as glass or acrylic (PMMA).

26. The optomechanical system (100) according to any one of the claims 18 to 25, wherein the first optical layer (41), the second optical layer (42), the third optical layer (43) and/or the fourth optical layer (44) is formed by molding, in particular by injection or compression molding.

27. The optomechanical system (100) according to any of the preceding claims, wherein the first optical layer (41) is made of a flexible material, such as silicone rubber.

28. The optomechanical system (100) according to any one of the preceding claims, wherein the number of primary optical elements (47) is equal to the number of light energy conversion elements (51).

29. The optomechanical system (100) according to any one the claims 1 to 27, wherein the number of primary optical elements (47) is bigger than the number of light energy conversion elements (51).

30. The optomechanical system (100) according to claim 29, wherein the light energy conversion layer (50) comprises a plurality of light shaping elements (56), wherein the light shaping elements (56) are positioned between the light energy conversion elements (51) and are configured to modify the path of the light impinging on them.

31. The optomechanical system (100) according to claim 29, wherein the light energy conversion layer (50) comprises a plurality of light diffusing elements (57', 57", 57"'), wherein the light diffusing elements (57', 57", 57''') are positioned between the light energy conversion elements (51) and have transmissivity factors different from the light conversion layer (50).

32. The optomechanical system (100) to any one of the preceding claims, comprising one or more sliders (27), arranged between the light energy conversion layer (50) and the optical arrangement (40), and one or more pre-constraining elements (28).

33. The optomechanical system (100) according to claim 32, wherein comprising sliding pads (29) between a slider (27) and a surface they are sliding on.

34. The optomechanical system (100) according to any one of the preceding claims, wherein the translation element (65) of the shifting mechanism (60) comprises at least one actuator (25) and a control system such that the optical arrangement (40) or the light energy conversion layer (50) can be moved in one or more degrees of freedom in a translational movement.

35. The optomechanical system (100) according to claim 34, wherein two or more actuators (25) are disposed in parallel to the same translational axis but at opposite ends of the translational element (65) and one or more actuators (25) are disposed in a direction perpendicular to the first two.

36. The optomechanical system (100) according to any one of the claims 34 or 35, wherein the actuator (25) is an electro-mechanical actuator, an electro-static actuator, an piezo-electrical actuator, an stick-slip actuator or a pneumatic actuator.

37. The optomechanical system (100) according to any one of the preceding claims, further comprising a feedback control loop to monitor the position of the translation element (65) and/or the output power of the optomechanical system, wherein the feedback control loop is for example an optical sensor, a magnetic sensor or a photovoltaic sensor, a power meter or a combination of several of these sensors.

38. The optomechanical system (100) according to any one the preceding claims, wherein a flexible membrane (15) seals the gap between the translation element (65) and the frame (10) while allowing the translational element (65) to move both laterally and vertically.

39. The optomechanical system (100) according to any of the preceding claims, wherein the light energy conversion elements (51) are interconnected by connection lines (53) provided on the light energy conversion layer (50), wherein the connection lines (53) are made out of a transparent conductive material, such as a transparent conductive oxide.

40. The optomechanical system (100) according to claim 39, wherein tertiary optical elements (49) are provided on top of the light energy conversion layer (50) in direction of the optical arrangement (40), wherein tertiary optical elements (49) are configured such that the amount of light impinging on the connection lines (53) is minimized.

41. The optomechanical system (100) according to any one of the preceding claims, wherein it comprises several optical arrangements (40), and several light energy conversion layers (50) and wherein the shifting mechanism (60) is configured such that it can move all optical arrangements (40) relative to all light energy conversion layers (50) or vice versa.

42. The optomechanical system (100) according to any one of the preceding claims, wherein the optomechanical system is arranged to be attached to a single-axis or dual-axis tracker.

43. A method for converting or transmitting a highly-directional component (81) of incident light (80) and for transmitting a diffuse component (82) of incident light (80) with an optomechanical system (100) according to any of the claims 1 to 42, comprising the steps of:
▪ directing the highly-directional component (81) of incident light (80) onto light energy conversion elements (51);
▪ converting the energy of the light directed onto the light energy conversion elements (51) into an output energy;
▪ transmitting the diffuse component (82) of incident light (80) through the optomechanical system (100);
▪ moving the optical arrangement (40) relative to the light energy conversion layer (50) or vice versa,
wherein the shifting mechanism (60) moves the optical arrangement (40) or the light energy conversion layer (50) translationally by one or more translation element (65) in such a way that the total output energy power of the light energy conversion elements (51) and/or the amount of light transmitted through the optomechanical system (100) is adjusted.

44. Use of an optomechanical system according to any one the claims 1 to 42 to convert light energy of the highly-directional component (81) of incident light (80) coming from the sun and to transmit the diffuse light component (82) of the incident light (80) to agricultural goods, such as plants.

45. Use of an optomechanical system according to any one the claims 1 to 42 as a window, skylight, and/or façade component.
